# EUROPÄISCHE PATENTANMELDUNG

(11) **EP 2 966 451 A2**
(43) Veröffentlichungstag der Anmeldung: **13.01.2016**
(21) Anmeldenummer: 15175929.7
(22) Anmeldetag: 18.04.2012
(51) Int. Cl.: G01P 1/02, G01P 15/08, G01P 15/093, G01D 5/34, G01R 15/24, G01R 33/038, G01R 33/032, G01R 33/028, G01L 1/04

(54) **ERFASSUNGSVERFAHREN UND SENSOR**

(30) Priorität: 18.04.2011 AT 2252011
(62) Teilanmeldung aus: 12722686.8
(71) Anmelder: Donau-Universität Krems, 3500 Krems/Donau (AT); Tecnet Equity Nö Technologiebeteiligungs Invest GmbH, 3100 Sankt Pölten (AT)
(72) Erfinder: Hortschitz, Wilfried, 2625 Schwarzau a. Stf. (AT); Kohl, Franz, 2345 Brunn am Gebirge (AT); Steiner, Harald, 2802 Hochwolkersdorf (AT); Sachse, Matthias, 2700 Wiener Neustadt (AT)
(74) Vertreter: Hutzelmann, Gerhard

(57) **Zusammenfassung**

Verfahren zur optomechanischen Erfassung und Wandlung eines mechanischen, elektrostatischen, magnetostatischen oder elektrodynamischen Eingangssignales in amplitudenmodulierte elektromagnetische Strahlungs-Ausgangssignale und daraus strahlungssensorisch gebildete elektrische Ausgangssignale mithilfe einer optomechanisch gebildeten Übertragungsfunktion sowie Vorrichtung zur Durchführung dieses Verfahrens.

Die vorgestellte Erfindung betrifft ein Verfahren zur opto-mikromechanischen WegErfassung, zur Signal-Umformung und Veränderung sowie Wandler, die nach diesem Verfahren arbeiten.

Dazu dient ein - relativ zur Umgebung und relativ zu definierten Licht- bzw. Strahlungszonen - bewegliches, dünnes flächiges Blendenelement. Mit besonders geformten Durchlässen lässt dieses in Abhängigkeit von der Position mehr oder weniger Licht oder vergleichbare elektromagnetische Strahlung durch. Der Strahlungsanteil (der Lichtstrom), der durch die Durchlässe gelangt, bildet eine Funktion die von der Relativposition bzw. der Relativwinkellage des Blendenelementes zu den Strahlungszonen abhängt.

Ein Photo- oder Strahlungsdetektor kann den auftreffenden Strahlungsfluss in elektrische Signale umwandeln.

Die gemessenen Größen können Wege oder Winkel, Beschleunigungen, Kräfte, elektrisch oder magnetisch bedingte Bewegungen oder Druck sein. Elektrische oder magnetische Feldstärken, elektrische Spannungen oder Ströme die über aktive kapazitive oder induktive Stellglieder in Bewegungen umgeformt werden, können gemessen werden.

## Beschreibung

Verfahren zur optomechanischen Erfassung und Wandlung eines mechanischen, elektrostatischen, magnetostatischen oder elektrodynamischen Eingangssignales in amplitudenmodulierte elektromagnetische Strahlungs-Ausgangssignale und daraus strahlungssensorisch gebildete elektrische Ausgangssignale mithilfe einer opto-mechanisch gebildeten Übertragungsfunktion sowie Vorrichtung zur Durchführung dieses Verfahrens.

Die vorliegende Erfindung betrifft ein messtechnisches Verfahren zum Erfassen, Wandeln und Manipulieren von bewegungsverursachenden, kraft- oder drehmomentbasierten und optischen Eingangssignalen in entweder amplitudenmodulierte Licht-Signale oder vergleichbare amplitudenmodulierte elektromagnetische Strahlungssignale sowie zur weiteren Wandlung derselben in elektrische Signale.

Des Weiteren betrifft die vorliegende Erfindung Wandler zur Durchführung des Verfahrens. Der Wandler ist eine mikromechanische Baugruppe, d.h. die Bewegungen sind auf sehr kleine Strecken, vorzugsweise unter 1 mm, zum Beispiel 10µm, oder sehr geringe Winkeländerungen vorzugsweise um einen Winkelbereich von weniger als 30° eingeschränkt. Zudem verändert der Wandler optische Signale, indem er elektromagnetische Strahlungspfade optomechanisch moduliert. Insofern kann ein solcher Wandler auch als Mikro-Optomechanischer Sensor bezeichnet werden.

### Stand der Technik

### Bekannte Vorrichtungen sind:

Elektrisch angesteuerte Lichtquellen insbesondere Leuchtdioden: diese können elektrische Eingangsgrößen in Licht eines bestimmten spektralen Bereiches wandeln, wodurch sich elektrische Signale auch über Lichtwellen an andere Orte übermitteln lassen (über Freiraum, Wellenleiter oder über Lichtleiter, wie Glasfasern). Infrarotdioden sind hier ebenfalls zu nennen.

Photodioden, Phototransistoren, Photovoltaik-Elemente, Strahlungsdetektoren und dergleichen: diese erlauben die Wandlung von Licht oder bestimmte elektromagnetische Wellen in elektrische Signale (Strom/Spannung).

Lichtmodulatoren: diese modulieren polarisiertes Licht mithilfe optisch aktiver Substanzen (Flüssigkristallen). Damit kann durch ein elektrisches Signal ein Lichtstrahl je nach Ausführung amplituden oder sogar phasenmoduliert werden. Hierbei dient die Ausrichtung der Flüssigkristalle durch eine elektrische Spannung für den Modulationseffekt.

Optokoppler: diese Vorrichtungen wandeln elektrische Eingangsgrößen in Lichtintensitäten durch Ansteuerung einer elektrisch betriebenen Lichtquelle und das Lichtsignal mithilfe von Photodioden oder Phototransistoren zurück in elektrische Ausgangsgrößen. Optokoppler dienen der Potentialtrennung elektrischer Signale.

Lichtschranken, auch im Infrarotspektrum: diese erlauben die Erfassung von passierenden Objekten quer durch einen Lichtpfad, indem der direkte optische Weg zwischen einer Strahlungsquelle und einem Strahlungssensor unterbrochen wird.

Inkrementelle optische Encoder: diese entsprechen kleinen Lichtschranken zur Erfassung von Anzahl von Strichen auf einem ansonsten transparenten Kode-Streifen oder einer Kodierscheibe. Für die Richtungserfassung sind meist zwei zueinander versetzte Strichraster vorgesehen. Diese bilden mit A und B bezeichneten Signale auf Photosensoren. Dadurch ergeben sich Sinus- und Cosinus-Signale bei einem Hell-Dunkel-Hell bzw. Dunkel-Hell-Dunkel Übergang aufgrund des Schattenwurfes des Strichrasters. Solche Encoder dienen der Erfassung von Stellwegen, Drehwinkeln oder Drehzahlen.

Optische Absolutwert-Encoder: diese geben für jede Stellposition oder jede zu erfassende Winkelstellung einen eindeutigen digitalen Code aus, welcher durch ein binäres Strichmuster durch mehrere miniaturisierte Lichtschranken abgebildet wird. Ein Beispiel ist in US 4,385,234 gezeigt, wo eine Kodierscheibe mit einer Ansteuerachse gegenüber einer Optik mit einer Lichtquelle und einer Sensormatrix in einem Gehäuse drehbar gelagert ist.

Mechanisch verstellbare fotografische Blende: diese, meist als Irisblende ausgeführte Vorrichtung ermöglicht die mechanische Veränderung der Öffnung eines Lichtdurchlasses bei Objektiven von Foto-Apparaten oder Filmkameras. Eine besondere Blendenform zur Verwendung als veränderlicher optischer Dämpfer ist in US 6,404,970 gezeigt, worin eine Mehrzahl an Öffnungen in einem Bauelement regelmäßig angeordnet ist. Dabei nimmt der Öffnungsdurchmesser der Öffnungen in einer Ausdehnungsrichtung des Bauelementes stetig zu, wodurch das Bauelement eine von der Position abhängige Lichtdurchlässigkeit aufweist.

Ein weiterer integrierter variabler optischer Dämpfer ist in FR 2 839 060 veröffentlicht, wobei ein Kammantrieb einen Umlenkspiegel in Abhängigkeit der angelegten Spannung in eine Lichtdurchgangsstrecke einführt, wodurch ein Teil der Lichtmenge in der Lichtdurchgangsstrecke aus dem Lichtkanal abgelenkt wird.

Schließlich muss auf eine eigene Vorveröffentlichung in ScienceDirect, Procedia Engineering 5 (Ende Oktober 2010, S.420-423) von Elsevier hingewiesen werden. Darin ist Vibrations-Sensor gebildet durch ein hybrides optisch-mikro-elektromechanischen System veröffentlicht. Eine Abbildung zeigt ein rechteckiges an mäanderförmigen Federn beweglich gelagertes Blendenelement. Dieses ist aus einer Silizium-Struktur aus einem SOI-(Silicon-on-insulator) Wafer gefertigt und weist quadratisch geätzte Öffnungen auf. Zusätzlich sind an den Längsseiten Kammstrukturen angebracht, deren Funktion in dieser Publikation nicht näher erläutert ist. Durch externe Schwingungsanregung ergibt sich eine Relativbewegung des Blendenelementes gegenüber einem Pyrex-Glas-Chip mit Chrom-Aufbringungen. Diese sind ebenfalls quadratisch und so angeordnet, dass je nach Lage des beweglich gelagerten Blendenelementes mit den Öffnungen gegenüber den Chrom-Flächen (Blenden), mehr oder weniger Licht von einer Leuchtdiode (LED) oberhalb des Glas-Chips auf einen Phototransistor unterhalb des Blendenelementes fällt.

Nachteilig bei dieser, den Stand der Technik naheliegend beschreibenden Vorrichtung ist, dass nur eine einzige und auch nur eine ganz bestimmte Weg-Lichtintensitäten-elektrisches Signal (mV/mm) Übertragungsfunktion vorliegt. Es gibt nur einen Auswerte-Phototransistor und somit maximal nur ein analoges elektrisches Ausgangssignal. Die Übertragungskennlinie des Phototransistors ist nicht linear und muss folglich elektronisch korrigiert werden, wenn ein linearer Zusammenhang zwischen Ein- und Ausgangsgröße gewünscht wird. Die Eingangsgrößen beschränken sich hier nur auf mechanische Schwingungsanregung durch Anregung von Vibrationen über das Gehäuse und Neigungen, bzw. Beschleunigung oder Verzögerungen in Richtung der Beweglichkeit des Blendenelementes. Die Beweglichkeit des Blendenelementes ist auf nur eine Richtung beschränkt. Die Dimensionen der Chrom-Blenden sind genau so groß wie die Dimensionen der Aperturen im Silizium-Blendenelement. Dadurch muss die Positionierung exakt erfolgen. Die Lichtintensität über die Fläche ist inhomogen. Auch der Sensor ist sehr groß und mittelt die durch die Öffnungen gelangende Lichtströme. Ein separates Erfassen einzelner Teillichtströme ist hier nicht möglich.

### Aufgabe der Erfindung

Die Erfindung soll nun die genannten Nachteile des Standes der Technik beheben und zusätzliche Funktionen ermöglichen. Es wurde daher ein Verfahren gesucht, welches über bereits beschriebene und bekannte Anwendungen und Übertragungsfunktionen hinaus, ein potentialgetrenntes, isoliertes Messen einer durch die Vorrichtung definierte Eingangsgröße aus einer Menge nunmehr unterschiedlicher möglicher Eingangsgrößen ermöglicht.

Mögliche Übertragungsfunktionen sollen durch eine Vorberechnung der Auswirkung der Form der Positions- oder Winkellage-abhängigen Schnittfläche einer geeignet gewählten Lichtprojektion mit der ortsabhängigen geeignet gewählten Lichtdurchlässigkeit bestimmbar sein. Die Vorrichtung zur Durchführung des Verfahrens soll dazu ganz speziell gewählte Querschnittsformgestaltungen der Lichtdurchlässe im beweglich gelagerten Blendenelement aufweisen, sowie dazu gepaart, speziell gewählte Formen oder Muster für die Lichtprojektion. Die Position oder Drehlage der Messmasse soll optisch erfassbar sein, indem die Messmasse auch als Teil eines mechanischen Lichtmodulationssystems wirksam wird, welches mehr oder weniger Licht in Abhängigkeit der relativen Lage seiner Komponenten durchlässt.

Wesentlich dabei ist, dass erfindungsgemäß zumindest eine Übertragungsfunktion durch die Formgebung der Komponenten des mechanischen Lichtmodulationssystems bzw. des Modulationssystemes für die elektromagnetischen Wellen gebildet wird, derart, dass über die Weg- oder Winkellage der Messmasse-Erfassung **zusätzlich zumindest eine sinnvoll nützbare Signalmanipulation** erfolgt.

In Bezug auf den Stand der Technik gilt dies insbesondere für eine, über eine rein analoge Weg-Lichtstrom-Signal-Übertragung oder über eine bekannte inkrementelles Weg-Pulszahl- oder Position-Absolutwert-Digital-Signalausgabe hinausgehende Manipulation des Lichtes.

Die Signalmanipulation kann beispielsweise die Aufgabe haben, die Nichtlinearitäten von Eingangsgrößen und von weg- oder winkelabhängigen Gegenkräften zu kompensieren, oder bewusst bestimmte Nichtlinearitäten auch stückweise bewusst einzubauen, beispielsweise vom Strecken- oder Winkelabschnitt des Bewegungsraumes abhängige unterschiedliche Steigung (z.B. für unterschiedliche Intensitäts -Messbereiche).

Im einfachsten Fall ist bereits die Funktion der elektrischen Spannung gegenüber dem Stellweg zweier dazu eingesetzter Kammelektroden als Kammantrieb nichtlinear; bei geringen Abständen ergeben sich höhere elektronische Spannungsänderungen je Wegabschnitt, als bei großen Abständen. Aber auch die Lichtquelle hat häufig inhomogene Verteilung, es müssten Diffusoren das Licht gleichmäßiger verteilen um bei anteilsmäßiger Abschattung auch gleiche Lichtanteile auf dem Lichtsensor zu erhalten. Der Lichtsensor selbst hat ebenfalls in der Regel kein lineares Verhalten.

Das Erfordernis einer Übertragungsfunktion wird heute in elektronischen Schaltungen durch eine mehr oder weniger komplexe Struktur aus Transistoren und passiven Bauelementen gebildet. Dazu ist für die Entwicklung ein Aufwand für Entwurf, Layout und Simulation erforderlich, aber auch für die Fertigung und den Test der elektronischen Struktur. Zudem ist die Genauigkeit dieser Anpassungsmethoden prinzipiell begrenzt. Aufgrund bestimmter Störstellendichte auf Siliziumscheiben, dem Basismaterial für die Gestaltung der elektronischen Struktur, können bestimmte Anteile der erzeugten elektronische Bauteile schon in der Produktion Ausfälle haben, wodurch es zur Produktionsausbeute unter 100% kommt, insbesondere bei größeren Schaltungen.

Messgeräte benötigen eine robuste, zuverlässige und möglichst genaue Umsetzung einer Eingangsgröße in eine Ausgangsgröße. Die erfassten Signale müssen an das Messsystem angepasst werden. Sind die Signale außerhalb des Messbereichs werden Anpassungsvorrichtungen benötigt. Sind die Signale zu klein, müssen sie verstärkt werden, dabei sollen aber Störsignale (Rauschen) unterdrückt werden. Sind die Signale zu groß müssen sie zunächst abgeschwächt werden. Bestimmte Signale verhalten sich exponentiell, andere werden z.B. logarithmisch wahrgenommen (z.B. Lautstärke, Helligkeit) weshalb zweckmäßig der Logarithmus der Messgröße gemessen und kontrolliert werden sollte. Manche Signale gehören gefiltert, manche linearisiert, manche werden für die Weiterverarbeitung digitalisiert. Bislang werden für all diese erforderlichen Anpassungen elektronische Schaltungen mit Verstärkern, Abschwächern, Integrierern, Logarithmierern, Vorrichtungen zur Abtastung und Digitalisierung, Kurvenanalysatoren, Frequenzanalysatoren und vieles andere mehr eingesetzt. Dies geschieht deshalb, um für eine bestimmte Eingangsgröße das gewünschte Ausgangssignal zu bekommen. In einem einfachen Fall kann das der Sensor nur eine Grenzwertüberschreitung erfassen (Sicherung, Alarm). Oder eine Betriebsanzeige visualisiert den Wert innerhalb der erlaubten Grenzen. Für komplizierte Anwendungen muss eine nichtlineare Eingangsgröße in ein lineares Ausgangssignal übergeführt werden. Manchmal müssen kleine Signale verstärkt (Expander), größere abgeschwächt (Kompressor) und ganz große Signale begrenzt werden (Limiter). So kann je nach Eingangsgröße eine unterschiedliche Übertragungsfunktion erforderlich sein. Besonders dafür konzipierte Wandler sollen beispielsweise auch mehrere Eingangs-Signalmanipulationen ermöglichen, wie unterschiedliche Verstärkung oder unterschiedliche Phasenverschiebung, parallel an mehreren optischen und/oder elektrischen Ausgängen.

Weitere Signalmanipulationen durch geeignete Ausbildungen können Modulation (eine bestimmte Eingangssignal-Frequenzvervielfachung, z.B. Verdoppelung, Verdreifachung), eine Signalvollweg- oder Halbwellengleichrichtung, oder aus der akustischen Manipulation bekannte Dynamikeffekte einzeln, parallel oder kombiniert erzielen, beispielsweise die eines Kompressors, eines Limiters (Begrenzers), oder von einem Enhancer, einem Expander oder einem Noise Gate. Digitale Signalumformungen sollen parallel zusätzlich ausgegeben werden können.

Mögliche Mess-Größen sollen sein: Stellwege, Drehwinkel, Kräfte auf eine kleine Messmasse, wie Gravitationskräfte, Beschleunigungskräfte und folglich auch lineare Beschleunigungen (z.B. Erdbeschleunigung), Fliehkräfte und somit Winkelgeschwindigkeiten (Drehraten), aber auch Neigungen gegenüber Gravitationskräften; darüber hinaus sollen auch Anwendungen möglich sein wo elektrostatische Kräfte zwischen einer Bezugselektrode und einer beweglich gelagerten Elektrode gemessen werden können oder Kräfte die magnetischen Ursprung haben (z.B. zwischen zwei Permanentmagneten, oder zwischen einem Permanentmagneten und einem magnetisierbaren Material, oder aufgrund zumindest einem Strom durchfluteten Leiter wechselwirkend mit einem weiteren stromdurchfluteten Leiter oder einem Permanentmagneten oder magnetisierbarem Material). In allen Fällen der Kraftmessung soll zumindest eine wegabhängige Gegenkraft vorgesehen sein, die ab einer bestimmten Auslenkung der Messmasse aus einer Ausgangs- oder Ruhelage die zu messende Kraft kompensiert. Bei elektrischen Größen, die in mechanische Stellwege umgeformt werden, soll sich eine völlige elektrische Entkopplung ergeben. Das ist insbesondere von Bedeutung, wenn das Lichtsignal über photoelektrische Wandler in elektrische, jedoch manipulierte Signale rückgewandelt wird.

### Vorteile der Erfindung

Durch die Vorrichtung kann ein Vergleich zweier Messgrößen erfolgen (z.B. mechanische Kraft in Abhängigkeit von einer Beschleunigung und Federkraft in Abhängigkeit zur mikromechanischen Auslenkung eines Wandler-Elements).

Das Verfahren erlaubt kurze Entwicklungszeiten oder Anpassungen von Signalwandlern mit spezieller Übertragungscharakteristik. Die Bildung der speziell gewünschten Übertragungscharakteristik benötigt keine elektronischen Bauelemente, da die Signalmanipulation auf blendenoptischen Weg erfolgen kann. Bei Bedarf können in einem Bauelement mehrere Übertragungsfunktionen parallel gebildet und durch mehrere Ausgänge ausgegeben werden. Verschiedene Übertragungscharakteristiken können additiv durch parallele Anordnung aufsummiert werden. Durch Beweglichkeit des mechanischen Bauteiles in mehr als eine (Dreh-) Richtung, können auch für jede Richtung unabhängige oder kombinierte Ausgangssignale gebildet werden.

Bei Messung elektrischer Größen kann eine völlig Potentialtrennung des Messkreises vom zu messenden Signal erfolgen. Manchmal muss hohe Spannung abgekoppelt werden um keine negative Wirkung auf den Messkreis zu haben. Das gilt auch bei der Signalübertragung von einem Ort mit einer bestimmten Energieversorgung zu einem anderen Ort mit einer anderen Energieversorgung. Manchmal sind unterschiedliche Elektrische Baugruppen in einem Schaltkasten zusammengestellt, die von unterschiedlichen Versorgungsspannungen versorgt werden. Es gibt Baugruppen die mit 5V (Volt) arbeiten, andere mit +/- 12V, wieder andere mit 3.3V Versorgungsspannung. Wenn diese miteinander Daten austauschen muss eine Pegelanpassung bzw. Potentialtrennung erfolgen. Hier sind optische Übertragungen sinnvoll.

Die mechanische Rückwirkung auf eine mechanische Messgröße kann aufgrund äußerst geringer Massen und sehr geringer Stellwege und Stellwinkel äußerst gering gehalten werden.

Das Ausgangssignal des Wandlers kann über Lichtleiter oder Wellenleiter einer Auswertung zugeführt werden.

Die gemessenen Eingangsgrößen dienen direkt der Modulation eines Lichtpfades oder der Modulation der Übertragungsstrecke der elektromagnetischen Welle. Die Licht- oder elektromagentische Wellen-Quelle kann, muss aber nicht am Wandler angebracht werden. Es können auch Lichtleiter das Licht zuführen oder spezielle Führungen für die elektromagnetischen Wellen dazu dienen, diese Wellen zum Wandler zu leiten. Grundsätzlich kann auch natürliche Beleuchtung (Tageslicht) oder künstliche Raumbeleuchtung der Umgebung als Lichtquelle dienen. Die Lichtquelle kann moduliert werden. Dadurch können Kreuzmodulation aus und Multiplikationsfunktionen ermöglicht werden. Es können mehrere Licht- oder Wellenquellen parallel eingesetzt werden auch mit unterschiedlichen Spektralanteilen für unterschiedliche Zonen.

### Lösung der Aufgabe

Die Aufgabe wird erfindungsgemäß durch ein neuartiges Verfahren zur optomechanischen Erfassung und Wandlung eines zu messenden Eingangssignales gelöst. Dieses Eingangssignal kann eine mechanische, eine elektrostatische, eine magnetische oder eine elektrodynamischen Größe sein, die dann über den Zwischenschritt durch Wandlung in ein Weg-Signal einen elektromagnetischen Strahlungskanal beeinflusst. Dadurch wird ein vom Eingangssignal abhängiges elektromagnetisches Ausgangssignal z.B. ein bestimmter Lichtstrom erzeugt. Dieser kann infolge wieder über einen strahlungsempfindlichen Sensor zum Beispiel einen Photosensor in ein elektrisches Signal gewandelt werden. Das ist zum Beispiel eine vom Eingangssignal abhängige elektrische Gleich- oder Wechselspannung oder ein Gleich- oder Wechselstrom. Das Ausgangssignal kann aber auch als Frequenz in einem elektrischen Wechselsignal dargestellt sein, beispielsweise durch einen elektrischen Schwingkreis (astabilen Multivibrator) mit einem lichtstrom-abhängigen frequenzbestimmenden Bauelement (z.B. Fotowiderstand einer RC-Widerstands-Kapazitäts-Zeitkonstante).

Erfindungsgemäß wird eine opto-mechanische Übertragungsfunktion gebildet, wobei Strahlungsanteile von einer elektromagnetischen Strahlungsprojektion, beispielsweise von einer Lichtprojektion, von einem speziellen Bauelement abhängig von dessen Position bzw. von dessen Winkellage durchgelassen bzw. abschattet werden.

Die elektromagnetischen Signale, die dafür zum Einsatz kommen, weisen vorzugsweise Wellenlängen im Bereich von 100 nm bis 10 µm auf und sind in den möglichen Raumausdehnungsrichtungen eingeschränkt. Sichtbare Strahlen dieser elektromagnetischen Strahlungsprojektion würden auf einer ebenen Projektionsfläche ein zuvor definiertes Muster mit zumindest einer äußeren Kontur und eventuell auch nicht bestrahlte oder abgeschattete Bereiche innerhalb der Kontur zeigen. Aber auch für nicht sichtbare elektromagnetische Strahlen gibt es definierte Auftreffzonen und Zonen wo keine Strahlung zugeführt wird.

Erfindungsgemäß trifft nun diese geometrisch form- und/oder mustervorbestimmte Projektion teils auf ein dünnes ebenes flächiges und vorzugsweise opakes Blendenelement und teils durch zumindest einen Strahlungsdurchlass an diesem Blendenelement, das frontal gegen die Quelle der Strahlungsprojektion ausgerichtet ist. Der Strahlendurchlass am Blendenelement hat eine geometrisch vorbestimmter und vorzugsweise geätzte Querschnittsflächenform. Somit ergibt sich in Abhängigkeit der Relativposition oder Verdrehung des Blendenelementes und damit seiner Strahlendurchlässe gegenüber den Strahlungszonen ein ganz bestimmter Lichtstrom oder ein ganz bestimmter Strahlungsanteil der Strahlungsprojektion durch diese Strahlendurchlässe. Das erfindungsgemäße Verfahren sieht nun vor, dass eine durch das Eingangssignal vorzugsweise geradlinige Relativbewegung in Hauptausdehnungsrichtung oder eine durch das Eingangssignal relative Winkeländerung des Blendenelementes um eine Normalachse auf die Hauptebene des Blendenelements gegenüber der Strahlungsprojektion durch das gemessene Signal erzwungen wird. Dazu muss entweder das Blendenelement zweckdienlich in einer Ebene parallel zur Flächenausdehnung beweglich gelagert sein oder für eine relative Winkeländerung um eine Achse drehbar gelagert sein und zwar relativ zur betrachteten Strahlenfront.

Die möglichen Eingangssignale verursachen Kräfte auf das Blendenelement, welches dadurch beschleunigt wird und sich infolge innerhalb der Lagerung bewegt. Gegen diese Kräfte sind erfindungsgemäß Gegenkräfte aus Rückstell-Elementen vorgesehen, die den kraftbasierten Eingangssignalen mit zunehmendem Weg Kompensationskräfte entgegenbringen, wodurch eine konstante Eingangsgröße einen konstanten Stellweg oder Stellwinkel bewirkt. Dadurch findet eine Kraft-Weg- bzw. eine Kraft-Winkel-Umsetzung statt.

Erfindungsgemäß wird nun das optisch oder photo- oder strahlungssensorisch erfassbares Ausgangssignal für die gegebene relativen Ortslage (x,y) oder relativen Orientierunglage (α) in einen Weg oder Winkel einen abhängigen Durchstrahlungsfluss umgesetzt. Wie viel Licht oder Strahlung im betrachteten Frequenzspektrum durch die speziell geformten Aperturen/Strahlungsdurchlässe dringt, ist durch die Schnittmenge (oder mathematische Faltung) der projizierten geometrischen Formen und Muster und den Strahlungsdurchlass-Querschnittsflächen position- bzw winkelabhängig gegeben. Da auch mehr als ein Sensor gegenüber den Licht- oder Strahlungsaustrittsseiten von mehreren Strahlungsdurchlässen angeordnet sein kann, können auch mehrere Signale aus den jeweiligen Schnittmengen gebildet werden.

Erfindungsgemäß wird dadurch zumindest eine vorbestimmte Übertragungsfunktion G(x,y, α) im eingeschränkten Bewegungsbereich (x₀ ≤ x ≤ xₘₐₓ, bzw. y₀ ≤ y ≤ yₘₐₓ, bzw. α₀ ≤ α ≤ αₘₐₓ) des Blendenelements entlang eines definierten vorzugsweise geradlinigen oder kreisbahnförmigen Weges (x₀ bis xₘₐₓ; y₀ bis yₘₐₓ; bzw. α₀ bis αₘₐₓ) gebildet. Jeder Strahlungssensor kann maximal vollständig mit Strahlung von einer Strahlungsquelle bedeckt sein oder minimal wird er von keiner Strahlung direkt betroffen. Der Sensor bildet daher ein elektrisches Signal, dass im Normalfall zwischen den Extremwerten (keine Strahlung, vollständige Bestrahlung) liegt, wenn Teilabschattung der Strahlung durch das Blendenelement erfolgt. Die Änderung des Licht-Strahlungsstromes kann sprunghaft erfolgen, wenn ein kurzer Weg-, oder eine kleine Winkeländerung des Blendenelementes einen starken Zuwachs der Strahlung oder alternativ eine starke Abschattung der Strahlung auf die Sensorfläche verursacht. Dies ist bei großen Breiten eines Strahlungsdurchlass-Abschnittes bei einem Schritt entlang der Wegstrecke oder sehr breiten Blendenabschnitten der, die max. die Breite des Sensorelementes sein sollte. (Bei winkelbasierten Änderungen gilt sinngemäß, dass eine großer Strahlungsdurchlass-Radiuslänge oder eine große Blenden-Radiuslänge im Winkelschritt ergibt. Ein geringer Zuwachs, eine geringe Abnahme des Strahlungsstromes ist hingegen durch sehr dünne Strahlungsdurchlässe, bzw. dünne Blenden entlang der Wegänderung und analog durch kurze radiale Durchlässe oder Blenden entlang der Winkeländerung erreichbar.

Vorteilhaft eignet sich dieses erfindungsgemäße Verfahren für Eingangssignale die auf Gravitationskraft, Trägheitskraft, Massenträgheitsmoment oder Fliehkraft beruhen, wobei diese Kräfte und auf die Masse des Blendenelementes beschleunigend einwirken.

Darüber hinaus kann das Eingangssignal auch vorteilhaft durch ein äußeres elektrisches (Gleichoder Wechsel-)Feld gebildet werden, wenn das Blendenelement dazu statisch aufgeladen werden kann. Aufgrund der Ladungstrennung wird durch das resultierende Elektrische Feld eine Kraft verursacht. Elektrische (Gleich- oder Wechsel-)Spannungen an entsprechenden Elektroden können vorteilhaft zur Bildung eines elektromotorischen Antriebs für das Blendenelement eingesetzt sein. Vorzugsweise kann ein kapazitiver Kammantrieb verwendet werden.

Auch ein äußeres magnetisches (Gleich- oder Wechsel-)Feld kann auf ein dazu magnetisches Blendenelement vorteilhaft als Eingangssignal dienen, wenn dadurch eine Kraft auf das Blendenelement verursacht wird.

Grundsätzlich ist der aus dem Blendenelement austretende Strahlungsfluss ein Maß für das (auch veränderte) Eingangssignal. Es kann bei sichtbarer Strahlung mit dem Auge erfasst werden. Wird nicht direkt die Durchstrahlung ausgewertet, ist es erfindungsgemäß vorteilhaft diese über einen strahlungsempfindlichen Sensor zu erfassen und in ein elektrisches Signal umzuwandeln.

Das kann direkt beim Blendenelement oder in einem über Lichtleitfasern überbrücktem Abstand erfolgen.

Besonders vorteilhaft ist es nichtlineare Übertragungseigenschaften durch zumindest eine Formgeometrie an der Strahlungsprojektion oder an den Strahlungsdurchlässen zu kompensieren. So können nichtlineare Wirkungen der Rückstellelemente kompensiert werden. Jede nichtlineare Kraft-Weg- bzw. Kraft-Winkel-Umsetzung kann linearisiert werden. Insbesondere kann die beim Einsatz von kapazitiven Kammantrieben bedingte nichtlineare Übertragungseigenschaft auf optischem Weg kompensiert werden; gleiches gilt für einen allenfalls nichtlinear wandelnden strahlungsempfindlichen Sensor. Durch die empirisch erfassten Nichtlinearitäten des Sensorsystems insgesamt, kann durch die Veränderung der Blendengeometrien in einem zweiten Entwicklungsschritt die Übertragungsfunktion linear gemacht werden.

Neben der Linearisierungsmöglichkeit ist es erfindungsgemäß sehr vorteilhaft, eine oder mehrere bestimmte vordefinierte nichtlineare Übertragungsfunktion(en) zu bilden. Das gegenständliche Verfahren erlaubt es die Übertragungsfunktion in ein Strahlungssignal oder mithilfe eines Strahlungssensors in ein elektrisches Signal stückweise für bestimmte Weg, bzw. Winkel-Abschnitte, durch die Potenz- und/oder Wurzelsumme ∑ Aᵢ u ^{(B_i)} zu beschreiben. Dabei ist i aus der Menge der ganzen Zahlen und Aᵢ und. B_i sind frei definierbare Konstanten aus der Menge der rationalen Zahlen und u ist die Variable des Weges in der x,y-Ebene bzw. für den Drehwinkel α . Solcherart beschriebene Übertragungsfunktionen können auch parallel, physisch getrennt oder kombiniert eingesetzt werden.

Ein paar Beispiele dazu: Ist B_i = 0 so ist die Übertragungsfunktion eine Konstante, d.h. entlang des Wegstückes ändert sich das Ausgangssignal nicht. Ist B_i = 1, so ist die Übertragungsfunktion in dem Wegstück bzw. Winkelabschnitt eine lineare Funktion mit der Steigung A;.

Grundsätzlich sind durch diese Beschreibung auch quadratische oder kubische Funktionsabschnitte, Funktionen höherer Ordnung, e-Funktionen, Sinus-, Cosinus-Funktionen oder Wurzelfunktionen, steigende oder fallende Kurven, aber auch Sprünge abgebildet.

Neben dem Verfahren ist auch die Vorrichtung zur Durchführung des Verfahrens Gegenstand der Erfindung.

Die erfindungsgemäße Vorrichtung weist vorteilhaft ein ebenes flächiges vorzugsweise opakes in einer Halterung beweglich gelagertes Blendenelement auf. Dieses ist vorzugsweise aus Silizium gebildet. Dazu hat das Blendenelement im Verhältnis zu seiner Flächenausdehnung eine geringe Dicke zumindest einen Strahlungsdurchlass. Der Durchlass soll vorteilhaft eine vorzugsweise durch Durchätzung gebildete Ausnehmung sein und weist eine geometrisch vorbestimmte Querschnittsflächenform auf. Zusätzlich ist die Vorrichtung mit entweder mit einem optischen Element zur Bildung einer geometrisch geformten Strahlungsprojektion ausgestattet, wobei das Licht bzw. die Strahlung von zumindest einer geeigneten Strahlungsquelle stammt. Solch eine Strahlungsquelle ist vorzugsweise eine Leuchtdiode (auch organisch) oder eine Leuchtdiodenmatrix, vorzugsweise als OLED-Display, oder eine Quantum-Dot-Anordung. Die Projektion kann auch direkt durch die Strahlungsquelle auf das Blendenelement erfolgen.

Wird zumindest ein optische Element zur Bildung der Strahlungsprojektion eingesetzt, so eignen sich dafür besonders optisch brechende vorzugsweise fokussierende Linsen oder Spiegel oder Umlenkprismen, ein zweites abschattendes Blendenelement vorzugsweise gebildet aus geometrisch angeordneten opaken Beschichtungen auf einem transparenten dünnen ebenen Element, vorzugsweise aus Glas oder Kunststoff. Vorteilhaft können Bündel von Lichtleitfasern vorzugsweise Glasfasern eingesetzt werden, deren Lichtaustrittsflächen knapp oberhalb des Blendenelementes enden und entweder in geometrisch vorbestimmter Anordnung positioniert sind. Oder sie sind vereinzelt für die Lichtleitung deaktiviert oder mit nicht lichtleitenden Fasern gemischt sodass sie eine geometrisch vorbestimmte Anordnung ergeben. Bei Einsatz von einem Spiegel, oder einer reflektierende Schicht in einem Winkel vor dem beweglichen Blendenelement kann auch ein nicht-reflektierendem Musterschichtauftrag die Blendenoptik unterstützen.

Zumindest ein strahlungsempfindliches Bauelement kann vorteilhaft entweder direkt vor der strahlungsabgewandten Seite des beweglich gelagerten Blendenelementes angeordnet sein, oder mit diesem über eine optischen Vorrichtung wie Spiegel, Lichtleiter, Prisma in Verbindung stehen. Als Strahlungssensoren eignen sich strahlungsabhängige Widerstände, Photodioden, Phototransistoren, CCD-Kamera-Sensoren oder CMOS-Sensoren oder auch Photovoltaik-Elemente.

Vorteilhaft ist eine Lagerung des Blendenelement durch Federaufhängungen. Diese kann aus demselben Material, vorzugsweise Silizium gebildet sein indem es gleich wie die Ausnehmungen für den Strahlungsdurchgang gebildet, beispielsweise geätzt wird. Weitere Lagerungsalternativen sind Kugellager, Wälzlager, hydraulisches Lager vorzugsweise auf einem Hydraulikölfilm, pneumatisches Lager oder Magnetlager. Somit sind auch Dämpfungen möglich.

Ist das Blendenelement einstückig zusammen mit Federelementen und der Halterung (Rahmen) aus Silizium gefertigt, indem es beispielsweise strukturgeätzt wurde, so ist es vorteilhaft wenn das Blendenelement in zumindest einer Hauptausdehnungsrichtung eine Kammstruktur aufweist, die zusammen mit einer seitlich des Blendenelementes angeordneten Gegen-Kammstruktur am Rahmen einen kapazitiven Sensor oder kapazitive Antriebsvorrichtung (Combdrive) bildet. Dadurch können angelegte elektrische Potentiale am Kamm und am Gegenkamm das Blendenelement in Bewegung versetzen. Umgekehrt können Messignale am Combdrive aufgrund mechanisch forcierte Antriebe (z. B. durch Vibrationen) zusätzlich zum optisch generierten Signal gebildet werden.

Alternative Antriebsvorrichtungen für das Blendenelement sind vorzugsweise mechanische Hebel (auch Piezoelemente, thermische Längenänderungen, Bimetallstreifen), Zahnrad-Zahnstangenpaarung, Magnete, magnetische Materialien, Spulen, elektromotorische Antriebe.

### Zeichnungen

Die vorliegende Erfindung wird anhand der nachfolgenden Zeichnungen näher beschrieben: Es zeigen:
**Fig.** 1 zeigt ein Blockdiagramm des Signalwandlungsverfahrens mit Ein- und Ausgangsgrößen und deren physikalischen Zusammenhänge bei vorzugsweise geradlinig erzwungenen Wegänderungen.
**Fig.** 2 zeigt ein Blockdiagramm des Signalwandlungsverfahrens mit Ein- und Ausgangsgrößen und deren physikalischen Zusammenhänge bei vorzugsweise auf Kreisbahn erzwungenen Wegänderungen oder bei Winkeländerungen.
**Fig.** 3 zeigt ein Blockschaltbild des erfindungsgemäßen Wandlers.
**Fig.** 4 zeigt eine beispielhafte Ausführung eines erfindungsgemäßen Wandlers in einer Schnittansicht quer zu einer Hauptausdehnungsrichtung der beweglichen Blende.
**Fig.** 5 ist eine Variation zur Ausführung in **Fig**.4**,** wobei die Anbindung der Lichtquelle **5** und des Lichtsensors **200** über Lichtleitungen 7 erfolgt.
**Fig.** 6 zeigt vier verschiedene Übertragungsfunktionen bei einem auf die maximale Wegstrecke sₘₐₓ normierten Weg und mit einem auf den maximalen Ausgangs-Strahlungsfluss normierten Ausgangssignal entsprechend der Paarung der Formgeometrien **104.**

In **Fig.** 7 ist der typische Strukturaufbau mit ruhendem optischen Blendenelement **6,** dem beweglichen Blendenelement **300** und der ruhenden Lichtstrom (Strahlungsfluss)-DetektorFläche gezeigt.

### Beschreibung der Ausführungsbeispiele

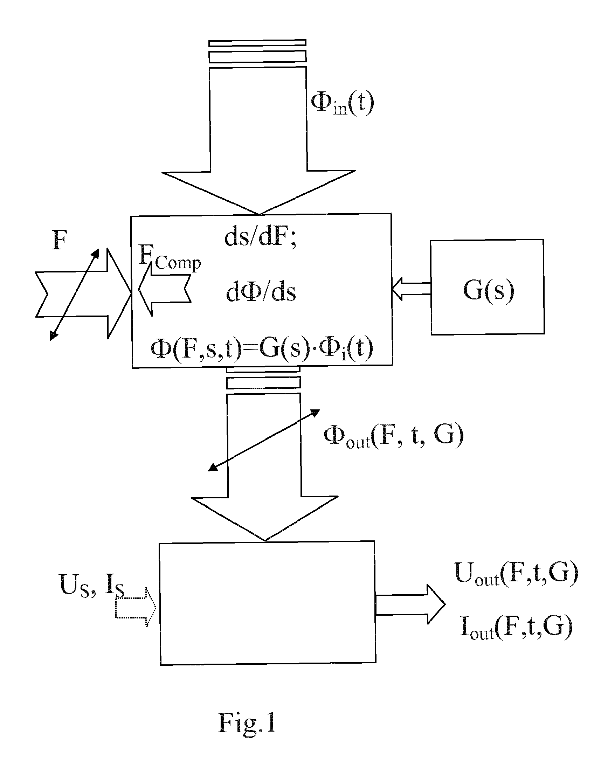

Die in **Fig.** 1 gezeigte Darstellung zeigt die drei Eingangssignale: den Strahlungseingangsfluss Φᵢₙ(t) als Strahlungsprojektion, eine Eingangskraft F gepaart mit einer, für eine bestimmte Auslenkung die Eingangskraft kompensierende Gegenkraft F_{Comp}, sowie die Geometriefunktion G(s). Der zentrale Block dieser Grafik, zeigt die mathematischen Zusammenhänge. Somit ergibt sich ein primäres Ausgangssignal Φₒᵤₜ(F,s,t) =G(s(F,F_{Comp})· Φᵢₙ(t)). s spiegelt dabei die in Grenzen veränderliche Relativposition der Strahlungsprojektion gegenüber der Position des beweglichen Blendenelementes wider und definiert sich in einem kartesischen Koordinatensystem in der Hauptausdehnungsebene der beweglichen Blende durch die x und y Koordinaten in einem definierten Wertebereich (xₘᵢₙ..x...xₘₐₓ, yₘᵢₙ...y...yₘₐₓ). Für jedes s ist eine Übertragungsfunktion G eindeutig beschrieben. Der normierte Übertragungswert bewegt sich zwischen 0 und 1, wobei bei 0 keine Strahlung durch die bewegliche Blende gelangt. Für G=1 müsste Φₒᵤₜ= Φᵢₙ erreichen. Für gewöhnlich und beim Nutzen mehrerer Übertragungsfunktionen parallel (additiv oder separat) zu einer Strahlungsquelle ist der Wert G jedoch meist kleiner 1. Wird das Strahlungs-Eingangssignal Φᵢₙ moduliert, zum Beispiel im MHz Bereich -gepulst betrieben, so geht diese Modulation auch im Ausgangssignal Φₒᵤₜ ein. Langsame mechanisch bedingte Wegänderungen erzeugen dann eine Amplitudenmodulation dieses MHz-Trägersignales. Das Strahlungs-Ausgangssignal Φₒᵤₜ ist eine Funktion der zeitlichen Änderung des Strahlungs-Eingangssignales sowie der zeitlichen kraftabhängigen Wegänderung und von der Formgeometrie der Blenden-Lichtprojektionspaarung. Das primäre Ausgangssignal Φₒᵤₜ kann ein modulierter Lichtstrom oder auch ein unsichtbarer Strahlungsfluss oder eine Kombination von beidem sein. Dieses Signal beinhaltet die wegbestimmende Kraftkomponente.

Fällt das primäre Ausgangssignal Φₒᵤₜ auf einen dafür geeigneten Signaldetektor oder Strahlungs/Stromwandler oder Strahlungs/Spannungswandler, entsteht ein sekundäres elektrisches Ausgangssignal Uₒᵤₜ oder Iₒᵤₜ. Es kann aber auch ein vom Strahlungsfluss abhängiges elektrisches Zeitsignal sein. Beispielsweise eine Periodendauer in Abhängigkeit vom Lichtstrom, oder eine Frequenzmodulation, mit einer vom Strahlungsfluss abhängigen elektrischen SignalFrequenz.

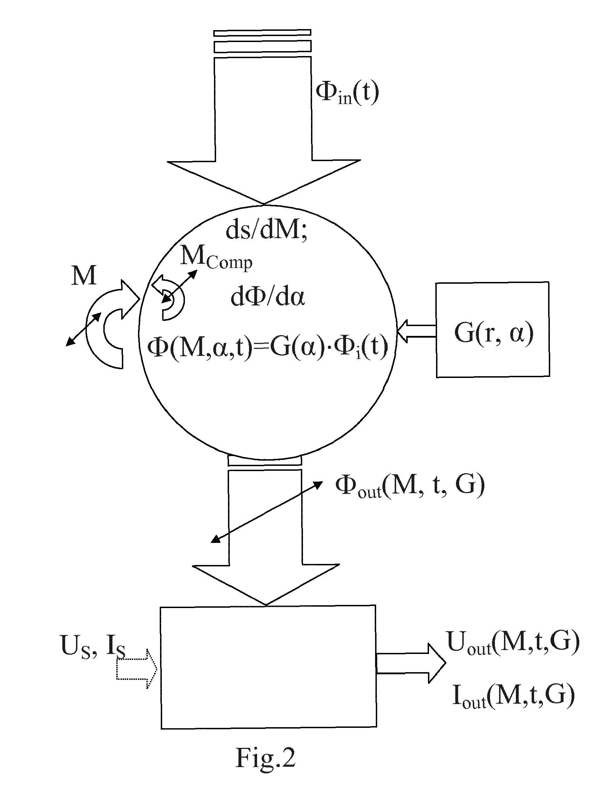

Anstelle einer Kraft-Gegenkraft-Paarung zur Kraft-Weg-Umformung, kann auch eine Drehmoment-Gegenmoment-Paarung zur Moment-Winkel-Umformung eine alternative Anwendung des erfinderischen Verfahrens darstellen. Dies ist funktionell im Blockdiagramm **Fig.**2 dargestellt. Die Ausgangs-Strahlungsfluss Φₒᵤₜ bestimmenden Variablen sind dann das gemessene Moment M, mithilfe des Kompensationsmoment M_{Comp}, über den Winkel α und die Modulation des Eingang-Strahlungsflusses Φᵢₙ über die Zeit und die Formgeometrie der Blenden-Lichtprojektionspaarung in Abhängigkeit vom relativen Drehwinkel α. α spiegelt dabei die in Grenzen veränderliche Relativposition der Strahlungsprojektion gegenüber der Position des beweglichen Blendenelementes wider und definiert sich in einem polaren Koordinatensystem normal auf die Hauptausdehnungsebene der beweglichen Blende durch die r und α gegebenen Koordinaten in einem definierten Wertebereich (rₘᵢₙ..r...rₘₐₓ, αₘᵢₙ... α ... αₘₐₓ). Für jedes α ist eine Übertragungsfunktion G eindeutig beschrieben.

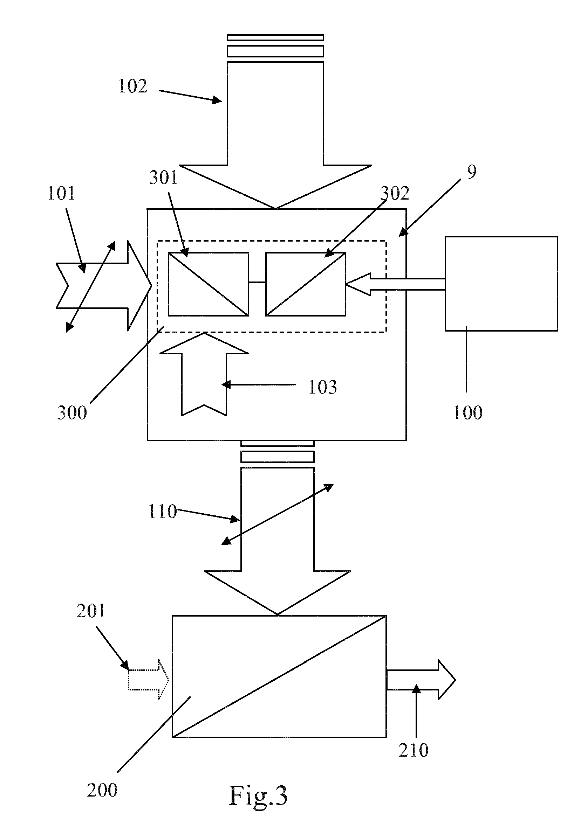

**Fig.**3 stellt nun das Blockschaltbild einer typischen Vorrichtung dar. Lichtstrom oder Strahlungsfluss ist hier als geometrisch geformte Strahlungsprojektion **102** zu betrachten. Diese weist gewöhnlich eine oder mehrere bestimmte Konturen auf und bewirkt bestrahlte und beschattete Zonen auf dem beweglich gelagerten Blendenelement **300.** Dieses wird mithilfe des mechanischen Eingangsignales **101** zum Beispiel eine Gravitationskraft (Erdanziehungskraft) bei entsprechender Lage gegenüber der Projektion **102** ausgelenkt. Wirkt eine mit der Auslenkung zunehmende Gegenkraft **103** zum Beispiel über eine Federaufhängung an einem starren Rahmen, so ist wie bei einer Federwaage, die Auslenkung proportional zur Beschleunigung auf die ausgelenkte Masse in Richtung der Gravitation. Dadurch ließe sich beispielsweise ein miniaturisierter Neigungssensor bauen. Das Federwaage-Element stellt dann den Block der Kraft-Weg-Umsetzung **301** oder bei einer entsprechenden drehbar gelagerten Vorrichtung die Drehmoment-Winkel -Umsetzung dar. Starr verbunden oder gar dasselbe Element wird nun erfindungsgemäß als Weg-Durchstrahlungs-Umsetzung-Vorrichtung **302.** G ist in der Formgeometrie der Strahlungs-Projektion **102** und des beweglichen Blendenelementes **300** inkorporiert. Somit wird es möglich ein sehr linearisiertes Strahlungs-Ausgangssignal **110** zu bilden, dass mögliche Nichtlinearitäten des mechanisch (oder elektrostatisch, oder magnetostatisch oder elektrodynamisch) gebildeten mechanischen Eingangssignales **101,** des Kraft-oder Drehmoment-Kompensationssignales **103** oder einer allfällig nachgeschalteten elektrischen Strahlungsfluss-Detektionseinrichtung **200** kompensiert werden. Erfindungsgemäß kann aber auch ein Signal oder mehrere Signale über die blendenoptisch erzeugte Übertragungsfunktion(en) **100** nach vorbestimmten Kriterien manipuliert werden. Ein Beispiel wäre ein exponentieller Lichtfilter. Zusammen mit einem strahlungsempfindlichen elektrischen Sensor **200,** können Vibrationen oder Bewegungs- oder Verdrehungs-Signale gezielt manipuliert werden und verschiedenste elektrischen Ausgangssignale bilden. Wird ein elektrostatischer Antrieb (CombDrive) eingesetzt, so können elektrische Signale direkt in Amplituden des Lichtstrom oder des Strahlungsflusses umgesetzt werden und über den strahlungsempfindlichen Sensor wieder in elektrische Signale. Dafür sind nur sehr wenige unterschiedliche Bauelemente erforderlich jedoch eine Vielzahl von Funktionen auch parallel bildbar. Über einen gewöhnlichen Optokoppler hinaus, können Funktionen in die Optik integriert werden, die andernfalls nur durch erheblichen Aufwand in einer elektronischen Schaltung möglich wären. Erfindungsgemäße Vorrichungen weisen ein dynamisches Verhalten auf, wodurch sich bei Schwingungsanregung auch ein frequenzabhängiges Verhalten ergibt. Die Resonanzfrequenz hängt dabei vom mechanischen Gesamtsystem (Masse, Federsteifigkeit, Dämpfung, Trägheitsmoment und dergleichen ab). Werden unterschiedliche diesbezügliche Elemente in einer Baugruppe integriert, z.B. mehrere unterschiedliche Massen, mit unterschiedlichen Lagerungen und Gegenkraft-Elementen, dann ergeben sich auch unterschiedliche Resonanzbedingungen, das kann mitunter vorteilhaft eingesetzt werden.

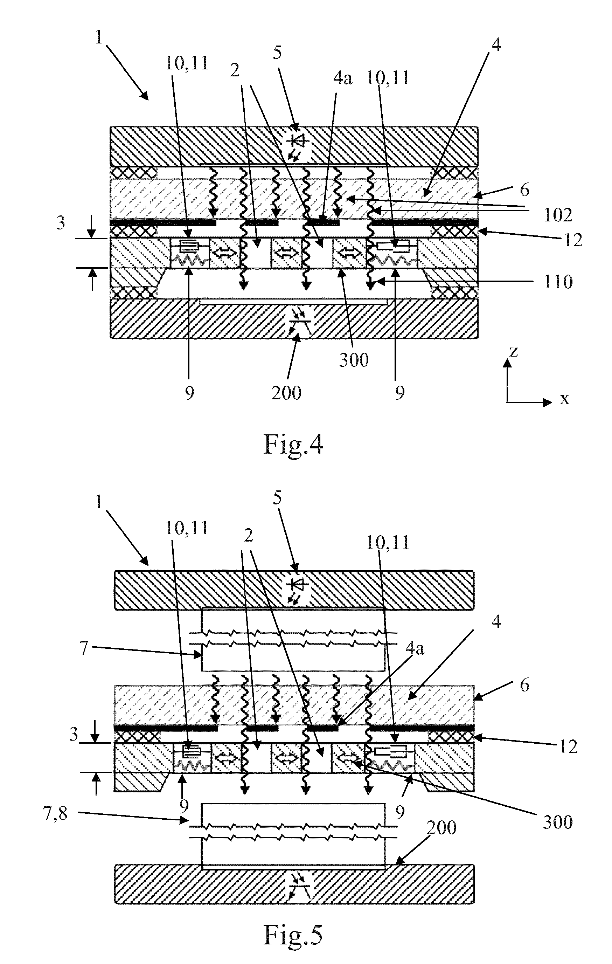

**Fig.** 4 zeigt einen lateralen Schnitt parallel zur x-Achse quer zur y-Achse eines in der x-y-Ebene ausgedehnten konstruktiven Elementes mit Schichtaufbau in z-Richtung als einfaches Ausführungsbeispiel einer teilweise symbolisch skizzierten erfindungsgemäßen Vorrichtung mit nur einer Lichtquelle. Als Strahlungsquelle **5** ist hier eine Leuchtdiode eingesetzt deren Leuchtfeld großflächig eine transparente Schicht des optisch aktiven Elementes **4** (aus Pyrex Glas) mit aufgebracheten opaken Zonen **4a** durchleuchtet. Die opaken Zonen **4a** stellen ein bezüglich der Strahlungsquelle ruhendes Blendenelement **6** dar. Ein Teil der Gesamtstrahlung wird dadurch entweder absorbiert oder reflektiert, wodurch der darunter liegende Bereich abgeschattet wird, und mit Ausnahme möglicher geringer Streustrahlung keine Strahlung empfängt. Unter dem ruhenden Blendenelement **6** befindet sich hier ein bewegliches Blendenelement **300,** welches z.B. aus einem flachen Silizium-Chip gebildet ist, indem die speziell geformten Ausnehmungen durch Ätzung erzeugt wurden, um Strahlungsdurchlässe zu bilden **2.** In y-Richtung wird die Öffnungsbreite gebildet und in x-Richtung die Öffnungslänge, sodass erfindungsgemäß für unterschiedliche x-Positionen der laterale Schnitt unterschiedliche differentielle Öffnungslängen zeigen. Analoges gilt für die Gestalt der opaken oder den lichtdurchlassenden Zonen des ruhenden Blendenelementes **6.** Um die Beweglichkeit des beweglichen Elementes zu ermöglichen sind Distanziervorrichtungen **12** und ein Lager **9** vorgesehen. Die Lagerung erfolgt hier über Biegefedern. Zusätzlich ist eine Combdrive (kapazitiver Kammantrieb) zwischen dem umgebenden Material und dem bis auf die Biegefedern freigestellten beweglichen Blendenelement **300** gefertigt. Die Strahlung, hier das Licht der Leuchtdiode **5,** gelangt in einer Strahlungsprojektion aufgrund des starren Blendenelementes **6,** auf das bewegliche Blendenelement **300.** Durch dieses gelangt je nach Auslenkung mehr oder weniger Licht durch die Strahlungsdurchlässe. Die Auslenkung hängt von der Kraft auf die Masse des beweglichen Blendenelementes gegen die Federkraft ab, oder von der durch die elektrische Spannung am Combdrive bedingte Kraft gegen die Federkraft der Biegefedern ab. Eine Beschleunigung nach rechts würde das bewegliche Blendenelement **300** aufgrund der Massenträgheit relativ nach links gegen die linke Biegefeder drücken, und die rechte Biegefeder entsprechend dehnen. Im dargestellten Abschnitt gelangt nur wenig Licht durch das bewegliche Blendenelement. In einer großen Auslenkungslage rechts oder links gelangen die Öffnungen jedoch aus dem Bereich der darüberliegenden abschattenden Blenden und es kann mehr Licht durch die Öffnungen. Die Strahlung gelangt schließlich auf einen strahlungsempfindlichen Sensor **200** (hier ein Phototransistor). Dazu gibt es am Markt bereits LEDs insbesondere Infrarot-LEDs die mit Transistoren abgestimmt sind und jeweils einen Parabolspiegel aufweisen und im Prototyp praktisch einsetzbar waren. Die gesamte Baugruppe kann äußerst klein ausgeführt werden und kann beispielsweise in Gehäuse, wie sie in der Elektronik üblich sind eingegossen werden.

Eine interessante Variante ist in **Fig.**5 gezeigt, hier erfolgt die Lichtzuführung über Lichtleiter **7** oder Lichtleitfaserbündel. Dadurch kann das mechanische Bauteil völlig von elektronischen Komponenten ferngehalten werden, womit sich insbesondere in der Hochspannungstechnik besondere Aspekte ergeben, da schädliche Entladungen aufgrund leitender Zuleiter vermieden werden können. Glasfasern haben eine sehr hohen Isolationswiderstand. Zwischen der Strahlungsquelle **5** und dem Strahlungsempfänger **200** ist hier ein längerer Abstand, der mit dem Lichtleiter überbrückt wird. Die Bildung des Strahlungssignales und die Verarbeitung des Strahlungsausgangssignales erfolgt örtlich entfernt von der Signalmanipulation. Die Signalwandlung ist hier wieder wie im Beispiel **Fig.**4. Lichtleitfasern bieten jedoch die Möglichkeit die Signalprojektion auch direkt ohne ruhendes Blendenelement durch die Positionierung des Faserendquerschnittes an bestimmten Stellen oberhalb des beweglichen Blendenelementes.

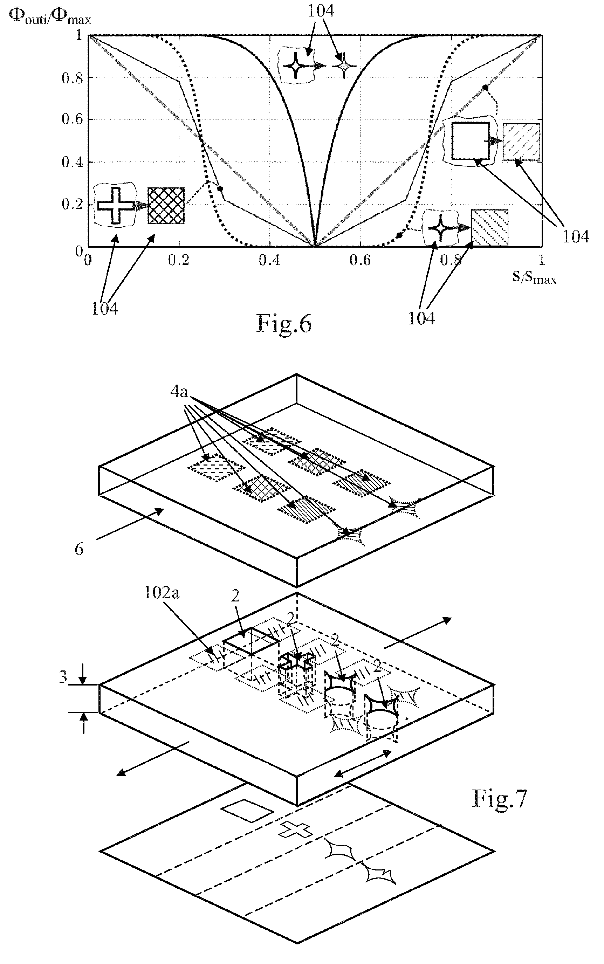

**Fig.**6 und **Fig.**7 sollen schließlich noch die prinzipielle Funktionsweise und beispielhafte Möglichkeiten anhand unterschiedlicher geometrischer Formpaarungen veranschaulichen. In **Fig.**6 ist das Ausgangssignal (normierte Darstellung) für vier verschiedene Blenden (ruhend) und Öffnungen (bewegt dazu) gezeigt. Der strichlierte Graph in **Fig.**6 zeigt einen linearen Verlauf entsprechend einer Paarung aus quadratischen Blenden mit quadratischen Aperturen entsprechend dem hintersten Abschnitt aus **Fig.**7. Ist die Apertur kreuzförmig wie im anschließenden Abschnitt in **Fig.**7, so bekommt der lineare Verlauf (siehe dünne Linie in **Fig.**6) entsprechend der Öffnungsbreite in Bewegungsrichtung zwei unterschiedliche Steilheiten, im Längsbalkenabschnitt des Kreuzes ist die Steilheit flacher als im Querbalkenabschnitt. Wird der Übergang vom Längsbalken in den Querbalkenbereich und zurück verlaufend gemacht, entsteht eine Übertragungsfunktion entsprechend der punktierten Linie in **Fig.**6, bei einer Anordnung entsprechend der dritten Zone von Links in **Fig.**7. Das 4. Paarungsbeispiel zeigt die Auswirkung, wenn auch die starre Blende eine verlaufende Kreuzform entsprechend der verlaufenden Kreuzform der Apertur des beweglichen Blendenelementes aufweist, rechte Paarung in **Fig.**7 mit dem Verlauf der dicken Kurve in **Fig.**6. In **Fig.**7 ganz unten ist die Strahlungsprojektion nach dem Strahlungsdurchgang durch die Blende **6** und das bewegliche Blendenelement **300** gezeigt. Werden vier Sensoren an die vier Bereiche der Signalverformung angeordnet, so können vier elektrische Ausgangssignale gebildet werden welche dem Signalverlauf in **Fig.**6 entsprechen. In einer möglichen höher komplexen Anordnung sind ein LED oder LCD-Display, wie sie aus elektronischen Suchern bekannt sind über dem beweglich gelagerten Blendenelement angeordnet und darunter befindet sich ein CCD oder CMOS Kameraelement mit ähnlichen Abmessungen. In diesem Fall kann durch die Ansteuerung des Display die Strahlungsprojektion auch nach der Fertigung verändert werden. Das Blendenelement kann eine Vielzahl von verschiedenen Grundformen aufweisen, die sich dann im Kameraelement entweder nach Wunsch zusammenaddieren lassen oder getrennt voneinander zur Signalbildung/Auswertung verwendet werden können.

### Ein nicht dargestelltes Ausführungsbeispiel:

Es ist auch denkbar, dass ein dem erfindungsgemäß nach dem Verfahren arbeitendes Bauelement 3 unterschiedlich farbliche Leuchtdioden nutzt, die je nach Auslenkung des Blendenelementes aufgrund eines erfassten Eingangssignales eine bestimmte Mischfarbe für das Auge erzeugen. Als Beispiel sei ein Temperatursensor z.B. für Brauchwasser mit Bimetallfeder genannt. Durch die Verformung der Bimetallfeder wird das Blendenelement gedreht oder verschoben, damit ändert sich die Lichtzusammensetzung von z.B. blau für kalt auf rot für heiß. Im Übergangstemperaturbereich ergeben sich verschiedene Mischfarben, z.B. grün für handwarme 38°.

### Bezugszeichenliste:

- Φᵢₙ(t): elektromagnetischer Eingangs-Strahlungsfluss, Lichtfluss von einer Lichtquelle (auch zeitlich (t) moduliert)
- ds/dF: differentielle Wegänderung ds aufgrund einer Kraft
- ds/dM: differentielle Wegänderung ds aufgrund eines Drehmomentes
- F: Kraft, Eingangsgröße für den Wandler (z.B.: Gravitation, Trägheitskraft, Fliehkraft, auch durch Druck verursacht)
- M: Drehmoment, Eingangsgröße für den Wandler (z.B.: Winkelbeschleunigung auf eine Masse)
- F_{Comp}: wegabhängige Kompensationskraft (z.B. durch Biegefedern)
- M_{Comp}: wegabhängiges Kompensationsmoment (z.B. durch Spiralfeder)
- dΦ/ds;: dΦ/ dα differentielle Änderung des Lichtflusses oder des elektromagnetischen Strahlungsstromes, aufgrund einer Wegänderung ds oder Winkeländerung dα
- G(s); G(α): Übertragungsfunktion durch die Formgebung und relativen Lage von sowohl den gebildeten Aperturen als auch von den definierten Bestrahlungszonen entlang eines Weges s oder eines Kreisbogens α
- Φₒᵤₜ(F,t,G), Φₒᵤₜ(M,t,G): elektromagnetischer Ausgangs-Strahlungsfluss, Lichtfluss nach der mechanisch modulierten Blende in Abhängigkeit des mechanischen Eingangssignales und der gewählten geometrischen Übertragungsfunktion (G)
- Uₛ, Iₛ: Spannungs- und Stromversorgung für den strahlungsempfindlichen Sensor (für Fotovoltaic nicht unbedingt erforderlich)
- Uₒᵤₜ(F,t,G), Uₒᵤₜ(M,t,G): Ausgangsspannung als Funktion der Eingangs-(kraft, bzw. drehmoment)-Größe, der Zeit (bei mechanisch und/oder optisch) modulierten Eingängen und der Geometrie der Aperturen und Bestrahlungszonen
- Iₒᵤₜ(F,t,G), Iₒᵤₜ(M,t,G): Ausgangsstrom als Funktion der Eingangs-(kraft, bzw. drehmoment)-Größe, der Zeit (bei mechanisch und/oder optisch) modulierten Eingängen und der Geometrie der Aperturen und Bestrahlungszonen,

**1** Wandlervorrichtung zum Wandeln von Kraft in Lichtstrom-, oder Strahlungsflussstärken bzw. zum Wandeln in elektrische Signale
**2** Strahlungsdurchlass
**3** Dicke des Blendenelementes
**4** optisch aktives Bauelement wie Spiegel, Linse, Blende, Gitter, Prisma, oder Lichtleitfasern
**4a** opake Zone auf transparentem Träger (z.B. Chrom-Schichte bestimmter Flächenform)
**5** Strahlungsquelle
**6** zweites, vorzugsweise bezüglich der Lichtquelle ruhendes Blendenelement
**7** Lichtleiter, Lichtleitfaser(n), Führung für elektromagnetische Strahlung
**8** optische Vorrichtung am Ausgang wie Spiegel, Lichtleiter, Prisma, Linse
**9** Lager für das bewegliche Blendenelement
**10** Kammstruktur
**11** Combdrive (Kammantrieb, kapazitiver Sensor)
**12** Distanziervorrichtung, z.B. SU-8 Schichte
**100** Übertragungsfunktion des optomechanischen Wandlers (basierend auf Geometrien der Projektion und der Strahlungsdurchlässe eines beweglich gelagerten Blendenelements)
**101** Eingangsignal (mechanisch, oder durch elektrostatische, magnetostatische oder elektrodynamisch verursachte Größen)
**102** Strahlungsprojektion
**102a** Abschattungszonen
**103** Gegenkräfte/Gegenmomente
**104** Formgeometrien
**110** Strahlungs-Ausgangssignal (Strahlungsfluss)
**200** Strahlungsempfindlicher Sensor
**201** Versorgungs- und Steuereingänge des Sensors (bei Photovoltaikelementen nicht erforderlich)
**210** elektrisches Ausgangssignal (Strom, Spannung)
**300** Blendenelement
**301** Kraft-Weg-Umsetzung oder Drehmoment-Winkel-Umsetzung
**302** Weg-bzw. Winkel-Durchstrahlungs-Umsetzung

## Patentansprüche

1. Verfahren zur optomechanischen Erfassung und Wandlung eines mechanischen, elektrostatischen, magnetischen oder elektrodynamischen Eingangssignales **(101)** in modulierte elektromagnetische Strahlungs-Ausgangssignale **(110)** und daraus strahlungssensorisch gebildete elektrische Ausgangssignale **(210)** mithilfe einer optomechanisch gebildeten Übertragungsfunktion **(100), dadurch gekennzeichnet, dass**
i. Strahlungsanteile von zumindest einer, die Hauptstrahlrichtung normal schneidenden Ebene - geometrisch form- und/oder mustervorbestimmten elektromagnetischen Strahlungsprojektion **(102),** deren Strahlen vorzugsweise Wellenlängen im Bereich von 100 nm bis 10 µm aufweisen, teils auf ein dünnes ebenes flächiges und vorzugsweise opakes Blenden-Element **(300)** treffen und teils durch zumindest einen Strahlungsdurchlass **(2)** an diesem Blendenelement **(300),** wobei der Strahlungsdurchlass **(2)** geometrisch vorbestimmte und vorzugsweise geätzte Querschnittsflächenform besitzt, in Abhängigkeit seiner Relativposition oder relativen Winkellage gegenüber den Strahlungszonen der Projektion **(102)** geleitet werden, und
ii. eine durch das Eingangssignal **(101)** vorzugsweise geradlinige Relativbewegung des in einer Ebene parallel zur Flächenausdehnung beweglich gelagerten und als Strahlungsprojektionsfläche dienenden Blendenelementes **(300)** erzwungen wird, oder eine durch das Eingangssignal relative Winkeländerung des Blendenelementes um eine Normalachse auf die Hauptebene des Blendenelements gegenüber der Strahlungsprojektion **(102)** erzwungen wird, und dass
iii. gegen die kraftverursachenden Eingangssignale **(101)** von der Position des Blendenelementes **(300)** gegenüber der Position der Strahlungsprojektion **(102)** abhängige Gegenkräfte **(103)** aus Rückstell-Elementen dienen, die die Kraft-Weg-bzw. die Kraft-Winkel-Umsetzung vornehmen und dass
iv. die durchgelassene von der relativen Ortslage **(x,y)** oder relativen Orientierunglage (**α**) abhängige Durchstrahlungsmenge zumindest ein optisch oder photo- oder strahlungssensorisch erfassbares Ausgangssignal **(110)** bildet, welches die Schnittmenge (oder mathematische Faltung) der geometrisch form- und/oder mustervorbestimmten Strahlungsprojektion mit der Summe aller geometrisch vorbestimmten Strahlungsdurchlass-Querschnittsflächen - zumindest eines Teilbereiches des Blendenelementes **(300)-** repräsentiert,
wodurch zumindest eine vorbestimmte Übertragungsfunktion G(x,y, α) im eingeschränkten Bewegungsbereich (x₀ ≤ x ≤ xₘₐₓ, bzw. y₀ ≤ y ≤ yₘₐₓ, bzw. α₀ < α ≤ α-ₘₐₓ) des Blendenelements entlang eines definierten vorzugsweise geradlinigen oder kreisbahnförmigen Weges (x₀ bis xₘₐₓ; y₀ bis yₘₐₓ; bzw. α₀ bis αₘₐₓ) gebildet wird.

2. Verfahren nach Anspruch 1, **dadurch gekennzeichnet, dass** das Eingangssignal **(101)** zumindest ein Signal der Gruppe: Gravitationskraft, Trägheitskraft, Massenträgheitsmoment und Fliehkraft ist und auf die Masse des Blendenelementes beschleunigend einwirkt.

3. Verfahren nach Anspruch 2, **dadurch gekennzeichnet, dass** das Eingangssignal **(101)** durch ein äußeres elektrisches (Gleich- oder Wechsel-)Feld gebildet wird, welche auf ein dazu statisch aufgeladenes Blendenelement **(300)** eine Kraft verursacht oder durch eine elektrische (Gleich- oder Wechsel-)Spannung erzeugt wird, wodurch Ladungen an einem elektromotorischen Antrieb vorzugsweise ein kapazitiver Kammantrieb für das Blendenelement **(300),** getrennt werden.

4. Verfahren nach einem der Ansprüche von 1 bis 3, **dadurch gekennzeichnet, dass** die Durchstrahlung **(110)** über einen strahlungsempfindlichen Sensor **(200)** erfasst und in ein elektrisches Signal **(210)** umgewandelt wird.

5. Verfahren nach Anspruch 4, **dadurch gekennzeichnet, dass** bekannte nichtlineare Übertragungseigenschaften bedingt durch nichtlineare Wirkung der Rückstellelemente oder aufgrund der einer nichtlinearen Kraft-Weg- bzw. Kraft-Winkel-Umsetzung **(301)** insbesondere beim Einsatz von kapazitiven Kammantrieben und/oder bedingt durch nichtlineare Übertragungseigenschaften des strahlungsempfindlichen Sensors **(200)** nach der Weg-Durchstrahlungs-Umsetzung **(302)** durch zumindest eine Formgeometrie **(104)** auf der Seite der Strahlungsprojektion oder der Strahlungsdurchlässe kompensiert werden.

6. Verfahren nach Anspruch 5, **dadurch gekennzeichnet, dass** zumindest eine, vordefinierte Übertragungsfunktion für die Weg-bzw. Winkel-zu-Durchgangsstrahlung- bzw. Weg- bzw. Winkel-in- "elektrisches Signal"-Wandlung **(100, 200)** auch stückweise über bestimmte Weg, bzw. Winkel-Abschnitte, - auch parallel, physisch getrennt oder kombiniert, - durch die Potenz- und/oder Wurzelsumme ∑ Aᵢ u (B_i) mit i aus der Menge der ganzen Zahlen und Aᵢ und B_i frei definierbare Konstanten aus der Menge der rationalen Zahlen beschrieben ist, und u für die Variable des Weges in der x,y-Ebene bzw. für den Drehwinkel α steht.

7. Vorrichtung **(1)** zur Durchführung des Verfahrens nach einem der Ansprüche von 1 bis 6,
**dadurch gekennzeichnet, dass** sie
i. ein ebenes flächiges vorzugsweise opakes in einer Halterung beweglich gelagertes Blendenelement **(300),** welches vorzugsweise aus Silizium gebildet ist, und das Blendenelement **(300)** im Verhältnis zu seiner Flächenausdehnung eine geringe Dicke **(3)** aufweist und zumindest einen Strahlungsdurchlass **(2),** der vorzugsweise eine durch Durchätzung gebildete Ausnehmung mit geometrisch vorbestimmter Querschnittsflächenform ist, und
ii. ein optisches Element **(4)** zur Bildung einer geometrisch geformten Strahlungsprojektion **(102)** mithilfe von Strahlung oder mindestens eine geeignete Strahlungsquelle **(5),** vorzugsweise eine Leuchtdiode,auch organisch, oder eine Leuchtdiodenmatrix, vorzugsweise als OLED-Display, oder eine Quantum-Dot-Anordung aufweist.

8. Vorrichtung nach Anspruch 7, **dadurch gekennzeichnet, dass** das optische Element **(4)** zur Bildung der Strahlungsprojektion **(102)** zumindest ein Element aus der Gruppe
• eine optisch brechende vorzugsweise fokussierende Linse;
• ein Umlenkprisma
• ein zweites abschattendes Blendenelement **(6)** vorzugsweise geometrisch gestaltete opake Beschichtungen auf einem transparenten dünnen ebenen Element, vorzugsweise aus Glas oder Kunststoff;
• ein Bündel von Lichtleitfasern **(7)** vorzugsweise Glasfasern deren Lichtaustrittsflächen knapp oberhalb des Blendenelementes **(300)** enden und entweder in geometrisch vorbestimmter Anordnung positioniert oder vereinzelt für die Lichtleitung deaktiviert oder mit nicht lichtleitenden Fasern gemischt die eine geometrisch vorbestimmte Anordnung ergeben;
• ein Spiegel, oder eine reflektierende Schicht in einem Winkel vor dem beweglichen Blendenelement **(300)** vorzugsweise mit fokussierender Oberfläche oder mit nicht reflektierendem Musterschichtauftrag
aufweist.

9. Vorrichtung nach Anspruch 8, **dadurch gekennzeichnet, dass** sie zumindest ein strahlungsempfindliches Bauelement **(200)** vorzugsweise ein Element aus der Gruppe: Photodiode, Phototransistor, CCD-Kamera-Sensor oder CMOS-Sensor, Photovoltaik-Element aufweist, wobei das strahlungsempfindliche Bauelement **(200)** entweder direkt vor der strahlungsabgewandten Seite des beweglich gelagerten Blendenelementes **(300)** angeordnet ist oder zumindest eine optischen Vorrichtung **(8)** der Gruppe Spiegel, Lichtleiter, Prisma zwischen der Strahlungsaustrittsseite des beweglichen Blendenelementes **(300)** und dem strahlungsempfindlichen Bauelement angeordnet ist.

10. Vorrichtung nach einem der Ansprüche 7 bis 9, **dadurch gekennzeichnet, dass** die Lagerung des Blendenelements **(300)** durch zumindest ein Element **(9)** der Gruppe: Federaufhängungen, Kugellager, Wälzlager, hydraulisches Lager vorzugsweise auf einem Hydraulikölfilm, pneumatisches Lager, Magnetlager unterstützt ist.

11. Vorrichtung nach einem der Ansprüche 7 bis 9, **dadurch gekennzeichnet, dass** das bewegliche gelagerte Blendenelement **(300)** als Mikro-Elektromechanisches System (MEMS) einstückig zusammen mit der Halterung vorzugsweise aus Silizium und vorzugsweise durch ein Ätzverfahren gebildet ist, wobei das Lager **(9)** vorzugsweise durch elastische Biegefeder-Elemente gestaltet ist und das resultierende Feder-Masse-System ein definiertes Resonanzverhalten aufweist.

12. Vorrichtung nach Anspruch 10, **dadurch gekennzeichnet, dass** das beweglich gelagerte Blendenelement **(300)** in zumindest einer Hauptausdehnungsrichtung eine Kammstruktur **(10)** aufweist, die zusammen mit einer seitlich des Blendenelementes **(300)** angeordneten Kammstruktur einen kapazitiven Sensor oder kapazitive Antriebsvorrichtung **(11)** (Combdrive) bildet.

13. Vorrichtung nach einem der Ansprüche 7 bis 11, **dadurch gekennzeichnet, dass** sie Vorrichtungen zum relativen Bewegen oder Antreiben des beweglichen Blendenelementes **(300)** gegenüber dem Element zur Strahlungsprojektion aufweist, vorzugsweise aus der Gruppe: mechanischer Hebel, sich bei Temperatur längenändernde Elemente oder Bimetallstreifen, Piezo-Elemente, magnetostriktive Elemente, Zahnrad-Zahnstangenpaarung, Magnete, magnetische Materialien, Spulen, elektromotorische Antriebe.
